# EUROPÄISCHE PATENTANMELDUNG

(11) **EP 2 352 178 A1**
(43) Veröffentlichungstag der Anmeldung: **03.08.2011**
(21) Anmeldenummer: 10152088.0
(22) Anmeldetag: 29.01.2010
(51) Int. Cl.: H01L 31/048, H01L 31/05, H01R 13/66

(54) **Solarmodulanordnungen und Diodenkabel**

(71) Anmelder: Saint-Gobain Glass France, 92400 Courbevoie (FR)
(72) Erfinder: Dr. Philipp, Jan Boris, 81739, München (DE)
(74) Vertreter: Lendvai, Tomas

(57) **Zusammenfassung**

Die Erfindung betrifft eine Solarmodulanordnung mit einem Solarmodul zur photovoltaischen Energieerzeugung, einem an das Solarmodul angeschlossenen Anschlussgehäuse zur Verbindung des Solarmoduls mit einer elektrischen Last, und einer zum Solarmodul antiparallel verschalteten Freilaufdiode, wobei die Freilaufdiode in einem an das Anschlussgehäuse und das Solarmodul angeschlossenen Diodenkabel enthalten ist. Weiterhin betrifft sie eine Solarmodulanordnung mit einem Solarmodul zur photovoltaischen Energieerzeugung, einem an das Solarmodul angeschlossenen ersten Anschlussgehäuse zur Verbindung des Solarmoduls mit einer elektrischen Last, einem an das Solarmodul angeschlossenen zweiten Anschlussgehäuse zur Verbindung des Solarmoduls mit einer elektrischen Last, und einer zum Solarmodul antiparallel verschalteten Freilaufdiode, wobei die Freilaufdiode in einem die beiden Anschlussgehäuse elektrisch miteinander verbindenden Diodenkabel enthalten ist. Des Weiteren erstreckt sich die Erfindung auf ein solches Diodenkabel.

## Beschreibung

Die Erfindung betrifft nach ihrer Gattung Solarmodulanordnungen nach dem Oberbegriff der nebengeordneten Patentansprüche. Des Weiteren erstreckt sie sich auf ein Diodenkabel zur Verwendung in solchen Solarmodulanordnungen.

Solarmodule zur photovoltaischen Umwandlung von Sonnenlicht in elektrische Leistung werden zunehmend zur Energieerzeugung eingesetzt. Hinsichtlich des Wirkungsgrads haben sich Dünnschichtsolarmodule auf Basis polykristalliner Chalkopyrit-Halbleiter als vorteilhaft erwiesen, wobei sich insbesondere Kupfer-Indium-Diselenid (CuInSe₂ bzw. CIS) aufgrund seines an das Spektrum des Sonnenlichts angepassten Bandabstands durch einen besonders hohen Absorptionskoeffizienten auszeichnet. Da mit einzelnen Solarzellen nur Spannungspegel von weniger als 1 Volt erreichbar sind, werden in der Regel mehrere Solarzellen in einem Solarmodul seriell verschaltet, um auf diese Weise eine technisch brauchbare Ausgangsspannung zu erhalten. Dabei bieten Dünnschichtsolarmodule den besonderen Vorteil, dass die Solarzellen schon während der Schichtenherstellung in integrierter Form seriell verschaltet werden können. In der Patentliteratur wurden Dünnschichtsolarmodule bereits mehrfach beschrieben. Lediglich beispielhaft sei auf die Patentschrift DE 4324318 C1 verwiesen.

Für einen Anschluss an eine elektrische Last verfügen Solarmodule über zumindest eine Anschlussdose, die typischer Weise auf der Rückseite des Solarmoduls angebracht ist. Die Anschlussdose enthält Anschlusskontakte der. Die elektrische Verbindung zwischen den Anschlusskontakten und der Solarzellenschaltung wird beispielsweise in Form von Metallbändern von der Solarzellenschaltung aus dem Modul heraus in die Anschlussdose geführt. In der praktischen Anwendung werden oft mehrere Solarmodule durch an die Anschlussdosen angeschlossene Anschlusskabel zu einem Modulstrang in Reihe verschaltet. Hierbei ist es bekannt, für jedes Modul eine Freilauf- bzw. Bypassdiode vorzusehen, die mit den Anschlusskontakten des Solarmoduls so verschaltet ist, dass sie im normalen Betriebszustand, in dem das Modul Strom liefert, in Sperrrichtung gepolt ist. Durch die antiparallel geschalteten Freilaufdioden kann eine Beschädigung von Solarmodulen oder durch Überbrückung der zeitlich begrenzte Ausfall des Modulstrangs zur Stromerzeugung verhindert werden, falls diese beispielsweise aufgrund einer Verschattung oder eines Moduldefekts keinen Strom liefern, da der von den anderen Solarmodulen gelieferte Strom über die Freilaufdiode fließen kann.

Demgegenüber besteht die Aufgabe der vorliegenden Erfindung darin, herkömmliche Solarmodule in vorteilhafter Weise weiterzubilden, wobei insbesondere die Fertigung vereinfacht und Herstellungskosten verringert werden sollen. Diese und weitere Aufgaben werden nach dem Vorschlag der Erfindung durch Solarmodulanordnungen mit den Merkmalen der nebengeordneten Patentansprüche gelöst. Vorteilhafte Ausgestaltungen der Erfindung sind durch die Merkmale der Unteransprüche angegeben.

Gemäß einem Aspekt der Erfindung ist eine Solarmodulanordnung gezeigt, die ein Solarmodul zur photovoltaischen Energieerzeugung umfasst. Typischer Weise ist das Solarmodul mit einer Mehrzahl in Reihe verschalteter Solarzellen versehen. Bei dem Solarmodul kann es sich um ein kristallines, multikristallines Silizium-Solarmodul oder um ein Dünnschichtsolarmodul mit integrierten, seriell verschalteten Solarzellen handeln. Insbesondere kann die Halbleiterschicht aus einer Chalkopyrit-Verbindung bestehen, bei der es sich beispielsweise um einen I-III-VI-Halbleiter aus der Gruppe Kupfer-Indium/Gallium-Dischwefel/Diselenid (Cu(InGa)(SSE)₂), beispielsweise Kupfer-Indium-Diselenid (CuInSe₂ bzw. CIS) oder verwandte Verbindungen, um Cadmium-Tellurid und / oder Dünnschichtsilizium handeln kann.

Die Solarmodulanordnung umfasst weiterhin ein (einziges) an das Solarmodul angeschlossenes Anschlussgehäuse zur Verbindung des Solarmoduls mit einer elektrischen Last, insbesondere zum seriellen Verschalten des Solarmoduls mit weiteren Solarmodulen. Dabei ist das Anschlussgehäuse an Anschlusskontakte des Solarmoduls angeschlossen, die durch die in Reihe verschalteten Solarzellen elektrisch miteinander verbunden sind.

In der erfindungsgemäßen Solarmodulanordnung ist weiterhin eine zum Solarmodul antiparallel verschaltete Freilauf- bzw. Bypassdiode vorgesehen, durch die ein Schutz des Solarmoduls bei fehlender Stromerzeugung beispielsweise infolge von Verschattung erreicht wird. Die beiden Anschlusskontakte des Solarmoduls sind zu diesem Zweck über die in Sperrrichtung verschaltete Freilaufdiode elektrisch miteinander verbunden.

Wesentlich hierbei ist, dass die Freilaufdiode in einem an das Anschlussgehäuse und das Solarmodul angeschlossenen Diodenkabel enthalten ist. Unter dem Begriff "Diodenkabel" wird hier und im Weiteren ein eine Diode enthaltendes biegsames Kabel, aber auch eine Diode enthaltendes, starres und an die Anschlussdose ansteckbares Modul, verstanden. Ohne besondere Vorkenntnisse sind die Diodenkabel funktionsgemäß mit dem Anschlussgehäuse dauerhaft und vor Umwelteinflüssen geschützt verbindbar.

Ein biegsames Kabel ist hierbei ein mit einer elektrischen Isolatorhülle ummantelter, bevorzugt einadriger Verbund von Drähten, welcher ein gleichförmiges oder ein in regelmäßigen Abständen wiederkehrendes gleichförmiges Querschnittsprofil aufweist.

Durch diese Maßnahme kann in vorteilhafter Weise erreicht werden, dass die Diode wahlfrei und bedarfsabhängig in die Solarmodulanordnung eingebaut werden kann und insbesondere in Anwendungen, bei denen eine Verschattung des Solarmoduls nicht zu erwarten ist, nicht eingesetzt wird. Dies ermöglicht eine einfache und kostengünstige Herstellung der Solarmodulanordnung. Zudem kann die Solarmodulanordnung in vorteilhafter Weise nachträglich, d. h. nach Herstellung und insbesondere wenn diese schon in der jeweiligen Anwendung in Stellung gebracht worden ist, mit der Freilaufdiode bestückt werden. Ein weiterer Vorteil der Erfindung ergibt sich auch aus der Tatsache, dass Solarmodule gemäß DIN EN 61646 zertifiziert werden müssen, so dass die Freilaufdiode bzw. das Diodenkabel separat zertifizierbar sind, wodurch in der industriellen Serienfertigung in erheblichem Umfang Kosten eingespart werden können. Weitere Vorteile der Erfindung ergeben sich aus der Beschreibung der konkreten Ausführungsbeispiele.

Bei einer vorteilhaften Ausgestaltung der erfindungsgemäßen Solarmodulanordnung ist das Diodenkabel über eine Kupplung, die ein mit einem Kupplungsgegenteil lösbar verbundenes Kupplungsteil umfasst, mit dem Anschlussgehäuse elektrisch verbunden, wodurch eine besonders einfache Bestückung, insbesondere Nachrüstung, der Solarmodulanordnung mit der Freilaufdiode ermöglicht ist. Dabei kann die Freilaufdiode auch in der Kupplung enthalten sein.

Gemäß einem weiteren Aspekt der Erfindung ist eine Solarmodulanordnung gezeigt, die ein wie oben beschriebenes Solarmodul zur photovoltaischen Energieerzeugung umfasst. Sie umfasst weiterhin ein an das Solarmodul angeschlossenes erstes Anschlussgehäuse und ein an das Solarmodul angeschlossenes zweites Anschlussgehäuse zur Verbindung des Solarmoduls mit einer elektrischen Last. Des Weiteren umfasst sie eine zum Solarmodul antiparallel verschaltete Freilaufdiode.

Wesentlich hierbei ist, dass die Freilaufdiode in einem die beiden Anschlussgehäuse elektrisch miteinander verbindenden Diodenkabel enthalten ist. Somit kann durch das Diodenkabel auch im Falle zweier Anschlussgehäuse wahlfrei und bedarfsabhängig eine einfache Bestückung bzw. Nachrüstung der Solarmodulanordnung mit der Freilaufdiode erreicht werden.

Bei einer vorteilhaften Ausgestaltung der Solarmodulanordnung ist das Diodenkabel jeweils über eine Kupplung, die ein mit einem Kupplungsgegenteil lösbar verbundenes Kupplungsteil umfasst, mit den beiden Anschlussgehäusen elektrisch verbunden, wodurch das Diodenkabel besonders einfach mit den Anschlussgehäusen verbunden werden kann. Dabei kann die Freilaufdiode auch in einer der beiden Kupplungen enthalten sein.

Bei einer weiteren vorteilhaften Ausgestaltung der Solarmodulanordnung sind die beiden Anschlussgehäuse jeweils mit einem Anschlusskabel zur Verbindung des Solarmoduls mit einer elektrischen Last versehen, wobei das Diodenkabel mit den beiden Anschlusskabeln elektrisch leitend verbunden ist. Diese Ausgestaltung kann technisch besonders einfach realisiert werden, wobei das Diodenkabel zum einfachen Anbringen über Kupplungen, die jeweils ein mit einem Kupplungsgegenteil lösbar verbundenes Kupplungsteil umfassen, mit den beiden Anschlusskabeln elektrisch verbunden sein kann. Dabei kann die Freilaufdiode auch in einer der beiden Kupplungen enthalten sein.

Vorteilhaft ist das Diodenkabel an seinen beiden Enden jeweils mit einem Kupplungsteil und einem Kupplungsgegenteil versehen, so dass einerseits eine Verbindung der beiden Anschlusskabel unter Zwischenschaltung der Freilaufdiode und andererseits eine Verbindung der Anschlusskabel mit einer elektrischen Last in einfacher Weise erreicht werden kann, ohne dabei konstruktive Veränderungen an den Anschlusskabeln vornehmen zu müssen. Hierbei ist es von Vorteil, wenn die Kupplungsteile und Kupplungsgegenteile des Diodenkabels jeweils mit einer Verpolsicherung zum Verhindern einer parallelen Verschaltung der Freilaufdiode mit dem Solarmodul versehen sind. Durch diese Maßnahme kann eine fehlerhafte Verschaltung der Freilaufdiode verhindert werden. Eine solche Verpolsicherung kann beispielsweise durch eine spezielle Farb- und/oder Formgebung der Kupplungsteile und/oder Kupplungsgegenteile des Diodenkabels verkörpert sein.

Gemäß einem weiteren Aspekt der Erfindung ist ein Diodenkabel zur Verwendung bei einer Solarmodulanordnung zu antiparallelen Verschalten der Diode gezeigt, welches an seinen beiden Enden jeweils mit einem Kupplungsteil und einem Kupplungsgegenteil versehen ist. Vorteilhaft sind die Kupplungsteile und/oder Kupplungsgegenteile jeweils mit einer Verpolsicherung zum Verhindern einer zum Solarmodul parallelen Verschaltung der Diode versehen, die durch eine spezielle Farb- und/oder Formgebung der Kupplungsteile beziehungsweise Kupplungsgegenteile verkörpert sein kann.

Kurze Beschreibung der Zeichnungen

Die Erfindung wird nun anhand von Ausführungsbeispielen näher erläutert, wobei Bezug auf die beigefügten Figuren genommen wird. Es zeigen:
- Fig. 1: eine schematische Darstellung eines ersten Ausführungsbeispiels der erfindungsgemäßen Solarmodulanordnung;
- Fig. 2: eine schematische Darstellung eines zweiten Ausführungsbeispiels der erfindungsgemäßen Solarmodulanordnung.

Ausführliche Beschreibung der Zeichnungen

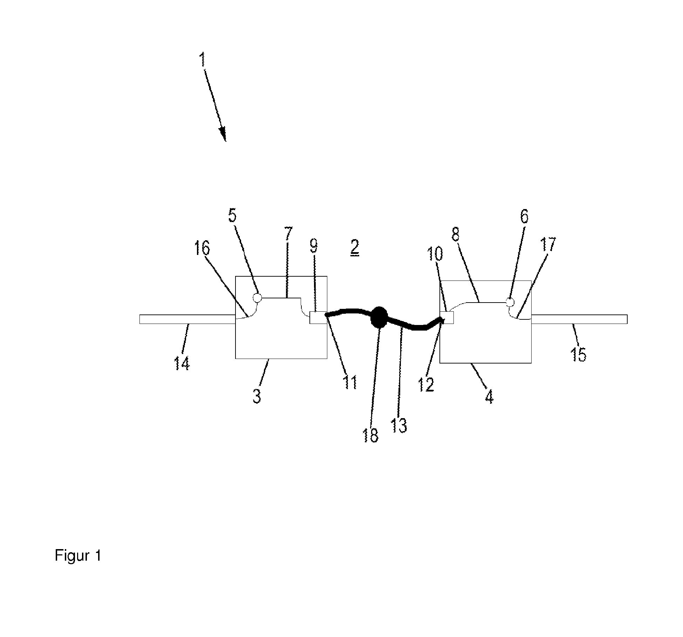

Sei zunächst Bezug auf Fig. 1 genommen, worin anhand einer schematischen Darstellung ein erstes Ausführungsbeispiel für eine insgesamt mit der Bezugszahl 1 bezeichnete Solarmodulanordnung veranschaulicht ist.

Die Solarmodulanordnung 1 umfasst ein zur photovoltaischen Umwandlung von Sonnenlicht in elektrische Leistung dienendes Solarmodul 2, beispielsweise Dünnschichtsolarmodul, mit einer Mehrzahl seriell verschalteter, integrierter Solarzellen. Das Solarmodul kann beispielsweise auf der so genannten Substratkonfiguration basieren. In diesem Fall verfügt es über ein gewöhnlich aus Glas bestehendes Substrat mit einem darauf aufgebrachten Schichtenaufbau aus dünnen Schichten, der einen Heteroübergang (pn-Übergang) bildet. Zu diesem Zweck kann der Schichtenaufbau eine auf dem Substrat angeordnete Rückelektrodenschicht, eine photovoltaisch aktive Absorberschicht aus einem dotierten Halbleiter, eine Pufferschicht, sowie eine für Strahlung im sichtbaren Spektralbereich transparente Frontelektrodenschicht umfassen. Zum Schutz vor Umwelteinflüssen ist der Schichtenaufbau in der Regel mit einer für Sonnenlicht transparenten Deckplatte versiegelt. Weiterhin umfasst das Solarmodul 2 einen ersten Anschlusskontakt und einen zweiten Anschlusskontakt, die beispielsweise in Form von Metallbändern ausgebildet sein können und durch die in Reihe verschalteten Solarzellen elektrisch miteinander verbunden sind.

Der grundsätzliche Aufbau eines solchen Solarmoduls 2 ist dem Fachmann, beispielsweise aus der eingangs genannten Druckschrift, an sich wohlbekannt, so dass hier nicht näher darauf eingegangen werden muss. Im Übrigen ist er für das Verständnis der Erfindung nicht wesentlich, aus welchem Grund das Solarmodul 2 in den Figuren nicht näher dargestellt ist.

Die Solarmodulanordnung 1 umfasst weiterhin zwei Anschlussdosen 3, 4 zur Verschaltung des Solarmoduls 2 mit einer elektrischen Last, insbesondere zur seriellen Verschaltung des Solarmoduls 2 mit anderen Solarmodulen. Hierbei ist eine erste Anschlussdose 3 über einen nicht näher dargestellten elektrischen Leiter, beispielsweise ein Flachleiter, der mit einer ersten Polklemme 5 der ersten Anschlussdose 3 verbunden ist, mit dem ersten Anschlusskontakt des Solarmoduls 2 elektrisch leitend verbunden. Der elektrische Leiter kann zu diesem Zweck beispielsweise durch eine Bohrung des Substrats des Solarmoduls hindurch geführt sein. In entsprechender Weise ist eine zweite Anschlussdose 4 über einen nicht näher dargestellten elektrischen Leiter, der mit einer zweiten Polklemme 6 der zweiten Anschlussdose 4 verbunden ist, mit dem zweiten Anschlusskontakt des Solarmoduls 2 elektrisch leitend verbunden.

Innerhalb der beiden Anschlussdosen 3, 4 sind an die beiden Polklemmen 5, 6 jeweils zwei weitere elektrische Leiter angeschlossen, nämlich in der ersten Anschlussdose 3 eine erste Buchsenverbindung 7, durch die die erste Polklemme 5 mit einer ersten Anschlussbuchse 9 elektrisch leitend verbunden ist, und eine erste Kabelverbindung 16, durch die die erste Polklemme 5 mit einem ersten Anschlusskabel 14 elektrisch leitend verbunden ist, sowie in der zweiten Anschlussdose 4 eine zweite Buchsenverbindung 8, durch die die zweite Polklemme 6 mit einer zweiten Anschlussbuchse 10 elektrisch leitend verbunden ist und eine zweite Kabelverbindung 17, durch die die zweite Polklemme 6 mit einem zweiten Anschlusskabel 15 elektrisch leitend verbunden ist. Wie bereits erwähnt, dienen die beiden Anschlusskabel 14, 15 dienen zum Anschließen des Solarmoduls 2 an eine elektrische Last.

Die beiden Anschlussdosen 3, 4 sind über ein Diodenkabel 13 elektrisch miteinander verbunden, zu welchem Zweck das Diodenkabel 13 an seinen beiden Enden mit nicht näher dargestellten Anschlussstecker 11, 12 versehen ist. Das Diodenkabel 13 ist somit durch die in die Anschlussbuchsen 9, 10 eingesteckten Anschlussstecker 11, 12 über lösbare elektrische Steckverbindungen mit den beiden Anschlussdosen 3, 4 verbunden. Das Diodenkabel 13 enthält eine Freilaufdiode 18, die antiparallel zum Solarmodul 2 verschaltet ist. Durch die Freilaufdiode 18 wird verhindert, dass das Solarmodul 2 beispielsweise im Falle einer Verschattung oder eines Moduldefekts durch Verpolung beschädigt und das verschattete Solarmodul überbrückt wird. Die Solarmodulanordnung 1 kann in einfacher Weise durch Einstecken des Diodenkabels 13 in die Anschlussdosen 3, 4 mit der Freilaufdiode 18 bestückt bzw. nachgerüstet werden. Somit kann die Freilaufdiode 18 wahlfrei und bedarfsabhängig eingesetzt werden, wodurch die Herstellungskosten für die Solarmodulanordnung 1 vermindert werden können. Zudem ist ein einfacher Austausch der Freilaufdiode 18 etwa bei einem Funktionsausfall ermöglicht. Nicht zuletzt unterliegt die im Diodenkabel 13 angeordnete Freilaufdiode 18 einer effizienten Kühlung.

Obgleich dies in Fig. 1 nicht gezeigt ist, kann in einer Modifikation der Solarmodulanordnung 1 das Diodenkabel 13 mit einer Dioden in einem starren Gehäuse ohne zweite Anschlussdose 4 direkt mit dem zweiten Anschlusskontakt des Solarmoduls 2 elektrisch leitend verbunden sein. Eine solche Solarmodulanordnung 1 umfasst demnach lediglich eine einzige Anschlussdose 3.

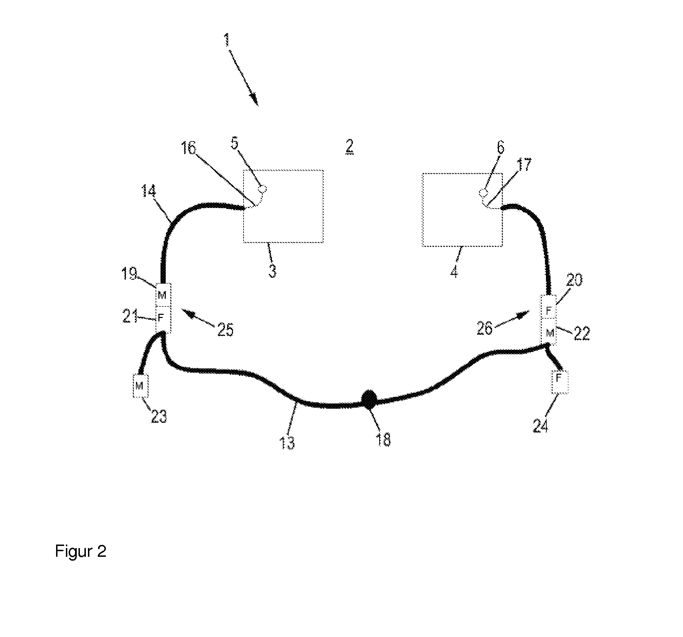

Es wird nun Bezug auf Fig. 2 genommen, worin anhand einer schematischen Darstellung ein zweites Ausführungsbeispiel der Solarmodulanordnung 1 veranschaulicht ist. Um unnötige Wiederholungen zu vermeiden, werden lediglich die Unterschiede zu dem in Fig. 1 gezeigten ersten Ausführungsbeispiel erläutert und ansonsten auf die dort gemachten Ausführungen Bezug genommen.

Demnach umfasst die Solarmodulanordnung 1 zwei Anschlussdosen 3, 4, die über eine erste Polklemme 5 bzw. zweite Polklemme 6 verfügen, die mit dem ersten Anschlusskontakt bzw. zweiten Anschlusskontakt des Solarmoduls 2 elektrisch leitend verbunden sind. Von den beiden Polklemmen 3, 4 geht jeweils nur eine einzige elektrische Leitung ab. Dies sind eine mit der ersten Polklemme 5 verbundene erste Kabelverbindung 16, die mit dem ersten Anschlusskabel 14 elektrisch leitend verbunden ist, sowie eine mit der zweiten Polklemme 6 verbundene zweite Kabelverbindung 17, die mit dem zweiten Anschlusskabel 15 elektrisch leitend verbunden ist. Die beiden Anschlusskabel 14, 15 sind über eine erste Steckverbindung 25 bzw. eine zweite Steckverbindung 26 mit dem die Freilaufdiode 18 enthaltenden Diodenkabel 13 elektrisch leitend verbunden. Die beiden Steckverbindungen 25, 26 sind jeweils aus einem lösbar miteinander verbundenen Steckteil und Steckgegenteil zusammengesetzt, wobei das Steckteil hier beispielsweise als männlicher Stecker (M) und das Steckgegenteil als weiblicher Stecker (F) ausgebildet sind. Zu diesem Zweck ist das erste Anschlusskabel 14 an seinem freien Ende mit einem ersten Steckteil 19 und das zweite Anschlusskabel 15 an seinem freien Ende mit einem ersten Steckgegenteil 20 versehen. Das Diodenkabel 13 gabelt sich an seinen beiden Enden jeweils auf, wobei an beiden Enden jeweils ein Steckteil und ein Steckgegenteil angeordnet sind. So ist das eine Ende des Diodenkabels 13 mit einem zweiten Steckgegenteil 21 versehen, das gemeinsam mit dem ersten Steckteil 19 die erste Steckverbindung 25 formt, und das andere Ende des Diodenkabels 13 mit einem zweiten Steckteil 22 versehen, das gemeinsam mit dem ersten Steckgegenteil 20 die zweite Steckverbindung 26 formt. Parallel zum zweiten Steckgegenteil 21 ist ein drittes Steckteil 23 an das Diodenkabel 13 angeschlossen. Parallel zum zweiten Steckteil 22 ist ein drittes Steckgegenteil 24 an das Diodenkabel 13 angeschlossen. Das dritte Steckteil 23 und das dritte Steckgegenteil 24 können zur seriellen Verschaltung des Solarmoduls 2 mit weiteren Solarmodulen dienen. Durch das Diodenkabel 13 kann die Solarmodulanordnung 1 in besonders einfacher Weise mit der Diode 18 bestückt bzw. nachgerüstet werden, ohne für die beidne Anschlusskabel 14, 15 ein spezielle Konfiguration vorzusehen.

Die Steckteile 22, 23 bzw. Steckgegenteile 21, 24 des Diodenkabels 13 können mit einer Verpolsicherung versehen sein, durch die verhindert wird, dass die Freilaufdiode 18 in fehlerhafter Weise in Durchlassrichtung mit dem Solarmodul 2 verschaltet wird. Die Steckteile bzw. Steckgegenteile können zu diesem Zweck beispielsweise mit einer Farbkodierung versehen sein oder durch ihre spezielle Formgebung gekennzeichnet sein. Denkbar ist aber auch jede andere geeignete Kennzeichnung der Steckteile bzw. Steckgegenteile.

Die Erfindung stellt eine Solarmodulanordnung zur Verfügung, bei der eine antiparallel zum Solarmodul verschaltete Freilaufdiode außerhalb der Anschlussdosen angeordnet ist, so dass die Freilaufdiode bedarfsgerecht eingesetzt werden kann. Dies ermöglicht eine Einsparung von Kosten und eine einfache Bestückung bzw. Nachrüstung der Solarmodulanordnung mit der Freilaufdiode. Zudem kann die Freilaufdiode bzw. das Diodenkabel unabhängig vom Solarmodul zertifiziert werden.

### Bezugszeichenliste

- 1: Solarmodulanordnung
- 2: Solarmodul
- 3: erste Anschlussdose
- 4: zweite Anschlussdose
- 5: erste Polklemme
- 6: zweite Polklemme
- 7: erste Buchsenverbindung
- 8: zweite Buchsenverbindung
- 9: erste Anschlussbuchse
- 10: zweite Anschlussbuchse
- 11: erster Anschlussstecker
- 12: zweiter Anschlussstecker
- 13: Diodenkabel
- 14: erstes Anschlusskabel
- 15: zweites Anschlusskabel
- 16: erste Kabelverbindung
- 17: zweite Kabelverbindung
- 18: Freilaufdiode
- 19: erstes Steckteil
- 20: erstes Steckgegenteil
- 21: zweites Steckgegenteil
- 22: zweites Steckteil
- 23: drittes Steckteil
- 24: drittes Steckgegenteil
- 25: erste Steckverbindung
- 26: zweite Steckverbindung

## Patentansprüche

1. Solarmodulanordnung (1), welche umfasst:
ein Solarmodul (2) zur photovoltaischen Energieerzeugung,
ein an das Solarmodul (2) angeschlossenes Anschlussgehäuse (3) zur Verbindung des Solarmoduls (2) mit einer elektrischen Last,
eine zum Solarmodul (2) antiparallel verschaltete Freilaufdiode (18),
**dadurch gekennzeichnet, dass** die Freilaufdiode (18) in einem an das Anschlussgehäuse (3) und das Solarmodul (2) angeschlossenen Diodenkabel (13) enthalten ist.

2. Solarmodulanordnung (1) nach Anspruch 1, **dadurch gekennzeichnet, dass** das Diodenkabel (13) über eine Kupplung (9, 11), die ein mit einem Kupplungsgegenteil (9) lösbar verbundenes Kupplungsteil (11) umfasst, mit dem Anschlussgehäuse (3) elektrisch verbunden ist.

3. Solarmodulanordnung (1) nach Anspruch 2, **dadurch gekennzeichnet, dass** die Freilaufdiode (18) in der Kupplung (9, 11) enthalten ist.

4. Solarmodulanordnung (1), welche umfasst:
ein Solarmodul (2) zur photovoltaischen Energieerzeugung,
ein an das Solarmodul (2) angeschlossenes erstes Anschlussgehäuse (3) zur Verbindung des Solarmoduls (2) mit einer elektrischen Last,
ein an das Solarmodul (2) angeschlossenes zweites Anschlussgehäuse (4) zur Verbindung des Solarmoduls (2) mit einer elektrischen Last,
eine zum Solarmodul (2) antiparallel verschaltete Freilaufdiode (18),
**dadurch gekennzeichnet, dass** die Freilaufdiode (18) in einem die beiden Anschlussgehäuse (3, 4) elektrisch miteinander verbindenden Diodenkabel (13) enthalten ist.

5. Solarmodulanordnung (1), wobei das Diodenkabel (13) ein biegsames Kabel enthält.

6. Solarmodulanordnung (1) nach einem der Ansprüche 4 oder 5, **dadurch gekennzeichnet, dass** das Diodenkabel (13) jeweils über eine Kupplung (9, 11; 10, 12), die ein mit einem Kupplungsgegenteil (9) lösbar verbundenes Kupplungsteil (11) umfasst, mit den beiden Anschlussgehäusen (3, 4) elektrisch verbunden ist.

7. Solarmodulanordnung (1) nach Anspruch 6, **dadurch gekennzeichnet, dass** die Freilaufdiode (18) in einer der beiden Kupplungen (9, 11; 10, 12) enthalten ist.

8. Solarmodulanordnung (1) nach einem der Ansprüche 4 oder 5, **dadurch gekennzeichnet, dass** die beiden Anschlussgehäuse (3, 4) jeweils mit einem Anschlusskabel (14, 15) zur Verbindung des Solarmoduls (2) mit einer elektrischen Last versehen sind, wobei das Diodenkabel (13) mit den beiden Anschlusskabeln (14, 15) elektrisch leitend verbunden ist.

9. Solarmodulanordnung (1) nach Anspruch 8, **dadurch gekennzeichnet, dass** das Diodenkabel (13) über Kupplungen (25, 26), die jeweils ein mit einem Kupplungsgegenteil (20, 21) lösbar verbundenes Kupplungsteil (19, 22) umfassen, mit den beiden Anschlusskabeln (14, 15) elektrisch verbunden ist.

10. Solarmodulanordnung (1) nach Anspruch 9, **dadurch gekennzeichnet, dass** die Diode in einer der beiden Kupplungen (25, 26) enthalten ist.

11. Solarmodulanordnung nach einem der Ansprüche 9 oder 10, **dadurch gekennzeichnet, dass** das Diodenkabel (13) an seinen beiden Enden jeweils mit einem Kupplungsteil (22, 23) und einem Kupplungsgegenteil (20, 21) versehen ist.

12. Solarmodulanordnung (1) nach Anspruch 11, **dadurch gekennzeichnet, dass** die Kupplungsteile (22, 23) und Kupplungsgegenteile (20, 21) des Diodenkabels (13) jeweils mit einer Verpolsicherung zum Verhindern einer parallelen Verschaltung der Freilaufdiode (18) mit dem Solarmodul (2) versehen sind.

13. Diodenkabel (13) mit einer Diode (18), zur Verwendung bei einer Solarmodulmodulanordnung (1) zum antiparallelen Verschalten der Diode (18) als Freilaufdiode mit einem Solarmodul (2), das an seinen beiden Enden jeweils mit einem Kupplungsteil (22, 23) und einem Kupplungsgegenteil (22, 23) versehen ist.

14. Diodenkabel (13) nach Anspruch 13, **dadurch gekennzeichnet, dass** die Kupplungsteile (22, 23) und Kupplungsgegenteile (20, 21) jeweils mit einer Verpolsicherung zum Verhindern einer parallelen Verschaltung der Diode (18) mit dem Solarmodul (2) versehen sind.

15. Diodenkabel (13) nach Anspruch 14, **dadurch gekennzeichnet, dass** die Verpolsicherung durch eine Farb- und/oder Formgebung der Kupplungsteile (22, 23) beziehungsweise Kupplungsgegenteile (20, 21) verkörpert ist.
